(19) Europäisches Patentamt

European Patent Office

Office européen des brevets

(11) **EP 1 646 073 A1**

(12) **EUROPEAN PATENT APPLICATION**
published in accordance with Art. 158(3) EPC

(43) Date of publication:
**12.04.2006 Bulletin 2006/15**

(51) Int Cl.:
*H01L 21/027* (1990.01)     *G03F 7/20* (1968.09)
*G02B 19/00* (1968.09)     *G02B 3/00* (1968.09)

(21) Application number: **03762869.0**

(22) Date of filing: **02.07.2003**

(86) International application number:
**PCT/JP2003/008399**

(87) International publication number:
**WO 2004/006308 (15.01.2004 Gazette 2004/03)**

(84) Designated Contracting States:
**DE GB NL**

(30) Priority: **03.07.2002 JP 2002195086**

(71) Applicant: **HITACHI VIA MECHANICS, Ltd.**
**Ebina-Shi,**
**Kanagawa 243-0488 (JP)**

(72) Inventors:
• **OSHIDA, Yoshitada, c/o Hitachi Ltd.,**
**Prod.Eng.Resea**
**Kanagawa 244-0817 (JP)**

• **MARUYAMA, Shigenobu c/o Hitachi Ltd.,**
**Prod.Eng.Rese**
**Kanagawa 244-0817 (JP)**
• **KOBAYASHI, Kazuo c/o Hitachi Via Mechanics**
**Ltd**
**Kanagawa 243-0488 (JP)**
• **NAITOU, Yoshitatu c/o Hitachi Via Mechanics Ltd**
**Kanagawa 243-0488 (JP)**
• **OSAKA, Yoshihisa c/o Hitachi Via Mechanics Ltd**
**Kanagawa 243-0488 (JP)**

(74) Representative: **Beetz & Partner**
**Steinsdorfstrasse 10**
**80538 München (DE)**

(54) **ILLUMINATING METHOD, EXPOSING METHOD, AND DEVICE FOR THEREFOR**

(57) The present invention provides a light exposure apparatus, and its method, comprising: an illumination optical system including: a light source array formed of a plural separate light sources arranged one-dimensionally or two-dimensionally; condensing optical system for condensing light emitted from each light source of the light source array; a light integrator for spatially decomposing the light condensed by the condensing optics, and thus generating a multitude of pseudo-secondary light sources; and a condenser lens for overlapping the light rays emitted from the multitude of pseudo-secondary light sources generated by the light integrator, and thus illuminating an illumination target region having a pattern to be exposed; and a projection optical system for projecting transmitted or reflected light onto an exposure target region of an exposure target object in order to expose the pattern to be exposed that is illuminated by the illumination optical system.

## FIG. 4

EP 1 646 073 A1

## Description

Technical Field

The present invention relates to an illumination method for irradiating the region to be illuminated with uniform and highly efficient illumination light, to a light exposure method that uses the illumination method, and to an exposure apparatus that uses the light exposure method for optically exposing patterns. More particularly, the invention concerns an illumination method, exposure method, and exposure apparatus (device) using a great number of semiconductor lasers.

Background Art

Conventional technologies have used a mercury lamp or an excimer laser as the light source for illuminating the object to be illuminated or to be subjected to light exposure. These light sources have been exceedingly inefficient in that most of the energy supplied for driving them changes into heat.

Disclosure of the Invention

In recent years, reduction in the wavelengths of semiconductor lasers (laser diodes: LDs) has progressed and LDs with light-emitting wavelengths of nearly 400 nm have come into existence, with the result that these LDs have become likely to be used for exposure as light sources alternative to mercury lamps. However, the output of one LD has its limits, and using multiple LDs, therefore, can hardly be avoided. Even if a number of LDs are arranged and uniformly irradiating the object to be illuminated with the outgoing light from each of the LDs is attempted, the directivity of the outgoing light from each light source takes nearly a Gaussian distribution and the light becomes strong near the center of the irradiated region and weak on the periphery thereof. In addition, in directions perpendicular to the principal light rays from the LDs, although the spread angle of one direction decreases, the spread angle of a direction perpendicular to this one direction becomes increases. And the rate between the two spread angles ranges from about 1:3 to 1:4. It has been impossible for such light from each LD to be emitted uniformly and efficiently to the desired illumination target region. In other words, there has occurred the contradictory event in which whereas attempting uniform illumination reduces efficiency, attempting the enhancement of efficiency deteriorates uniformity.

In view of solving the above problem, an object of the present invention is to provide an illumination method and apparatus adapted to irradiate an irradiation target object with high efficiency and uniformly by use of more than one light source having small light-emitting energy per semiconductor laser or the like, and thus realizing high-performance illumination with saved energy.

Another object of the present invention is to provide a light exposure method and apparatus capable of realizing high-quality pattern exposure with a high throughput.

In order to achieve the above objects, an aspect of the present invention is characterized in that light is first emitted from multiple light sources arrayed separately in a one-dimensional or two-dimensional fashion, such as LDs, then the emitted light from each of the multiple light sources is spatially decomposed by a light integrator to generate a large number of pseudo-secondary light sources, and light rays from the large number of pseudo-secondary light sources are overlapped using a condenser lens and applied to the region to be illuminated. In order to achieve the light source array, a large number of light sources or the secondary light sources obtained from the light sources are arranged in an almost uniform distribution in a region approximately analogous to the shape of the region to be illuminated. With this configuration, uniform and highly efficient illumination can be implemented.

In another aspect of the present invention, by forming the above light integrator made up of an array of multiple rod lenses, and making the aspect ratio of the sectional shape of each rod lens almost equal to the aspect ratio of the region to be illuminated, the light emitted from the light sources arranged on a two-dimensional plane or from the secondary light sources can be applied most efficiently and uniformly to the region to be illuminated, and illumination optics can thus be configured into a relatively compact form.

According to the configurations described above, it becomes possible for irradiation nonuniformity at low spatial frequencies to be suppressed almost completely on the object to be illuminated.

However, if LDs are used as the light sources, and the light emitted from each of the LDs is passed through the light integrator formed of the multiple rod lenses, the light emitted from one LD and passed through each rod lens will interfere on the object to be illuminated, and thus form interference fringes. Accordingly, the illumination light will become nonuniform at high spatial frequencies. If the number of LDs is greatly increased, such nonuniformity at high spatial frequencies will diminish, but not completely disappear.

Therefore, according to the present invention, a modulator that varies wavefronts is interposed in the optical path of light immediately before the light entering the above light integrator, or in the optical path of the light immediately after being emitted from the light integrator. This makes it possible to change the above nonuniformity at high spatial frequencies and hence create time-averaged, almost completely uniform illumination light not depending on spatial frequencies.

In yet another aspect of the present invention, a beam divergence angle is adjusted such that the divergence angle of the light emitted from the above-mentioned multiple light sources or from the secondary light sources obtained from the multiple light sources stays within the rate of 1 versus 1.5 with respect to any two directions within a plane vertical to the optical axis of the emitted light. This makes it possible to effectively use the outgoing light from the light sources as illumination light at the plane of incidence of the light integrator usually having a circular effective diameter. That is, the beam divergence angle is adjusted by using cylindrical lenses. More specifically, adjustment of the beam divergence angle is accomplished by arranging, longitudinally along the optical path, two kinds of cylindrical lenses whose focal lengths differ according to the divergence angle between the two orthogonal axes of the LDs.

In a further aspect of the present invention, the energy of the light emitted from each of multiple light sources is controlled to stay within a desired, fixed value. It is possible, by conducting the control in this way, to obtain the uniformity of illumination light and to maintain constant intensity of the illumination light.

In a further aspect of the present invention, by making the emitted light from the above-mentioned multiple light sources or from the secondary light sources obtained from the multiple light sources enter the associated positions on the above light integrator via condensing optics, uniform and directive uniform illumination not depending on the illumination location can be realized.

According to the illumination methods described above, it becomes possible to obtain uniform illumination light from a great number of separate light sources, illuminance nonuniformity within the region of a mask or a two-dimensional light modulator (or the like) that is to be illuminated is controlled to stay within $\pm 10\%$, and it has thus become possible for the first time for 30% or more of the energy of outgoing light from the multiple light sources to reach the region to be illuminated.

In a further aspect of the present invention, outgoing light from separate multiple light sources, especially from a semiconductor laser array of multiple light sources, is applied to the object to be illuminated (for example, a mask, a reticule, or a two-dimensional light modulator for maskless exposure use, such as a liquid-crystal type of two-dimensional light modulator or a digital mirror device, etc.), by use of any illumination method or illumination apparatus described above, and light exposure is thus conducted. By doing so, high-quality exposure illumination light taking a uniform intensity distribution and having the desired directivity can be obtained.

Highly efficient and uniform illumination can be implemented particularly by arranging multiple light sources into a shape analogous to the rectangular region to be illuminated, making the light obtained from these light sources enter a light integrator at the desired angle of incidence, and using the resulting outgoing light as the light irradiated onto the region to be illuminated. When semiconductor lasers are to be used as the light sources, if a modulator that varies wavefronts is used in front of or at rear of the light integrator, any interference fringes of the laser light become removable and uniform illumination can thus be obtained. Use of such illumination for light exposure of substrates allows high-throughput and high-quality pattern exposure.

Brief Description of the Drawings

FIG. 1 is a configuration diagram showing in perspective a first embodiment of an exposure apparatus according to the present invention;

FIG. 2 is a diagram showing the relationship between semiconductor laser light sources, shaping of the beams emitted therefrom, and a light integrator unit;

FIG. 3 is a perspective view that shows beam shaping with cylindrical lenses;

FIG. 4 is an explanatory diagram of an array of semiconductor lasers;

FIG. 5 is a diagram showing an arrayed condition of rod lenses at a light integrator;

FIG. 6(A) is a front view explaining the relationship between incoming light and outgoing light with respect to the rod lenses that constitute the light integrator;

FIG. 6(B) is a sectional view taken along line A-A of FIG. 6(A);

FIG. 6(c) is a side view of FIG. 6(A);

FIG. 7 is a configuration diagram showing in perspective a second embodiment of an exposure apparatus according to the present invention;

FIG. 8 is a diagram explaining the relationship between a modulator adapted to vary wavefronts, and a light integrator unit;

FIG. 9(A) is a front view showing in detail the modulation that varies wavefronts;

FIG. 9(B) is a diagram showing the shape of the surface of section C-C shown in FIG. 9(A);

FIG. 10 is a configuration diagram showing in perspective a third embodiment of an exposure apparatus according to the present invention;

FIG. 11 is a configuration diagram showing in perspective a fourth embodiment of an exposure apparatus according to the present invention;

FIG. 12 is a configuration diagram showing in perspective a fifth embodiment of an exposure apparatus according to the present invention;

FIG. 13 is a configuration diagram showing in perspective a sixth embodiment of an exposure apparatus according to the present invention;

FIGS. 14(A) and 14(B) are diagrams for explaining respective different examples of arranging multiple light sources;

FIG. 15 is a diagram showing the case in which multiple laser light sources are used as a light source array; and

FIG. 16 is a diagram showing an arrangement in which multiple types of light sources are used.

Best Mode for Carrying Out the Invention

Preferred embodiments of an illumination method and a method and apparatus for light exposure according to the present invention will be described below with reference to the accompanying drawings.

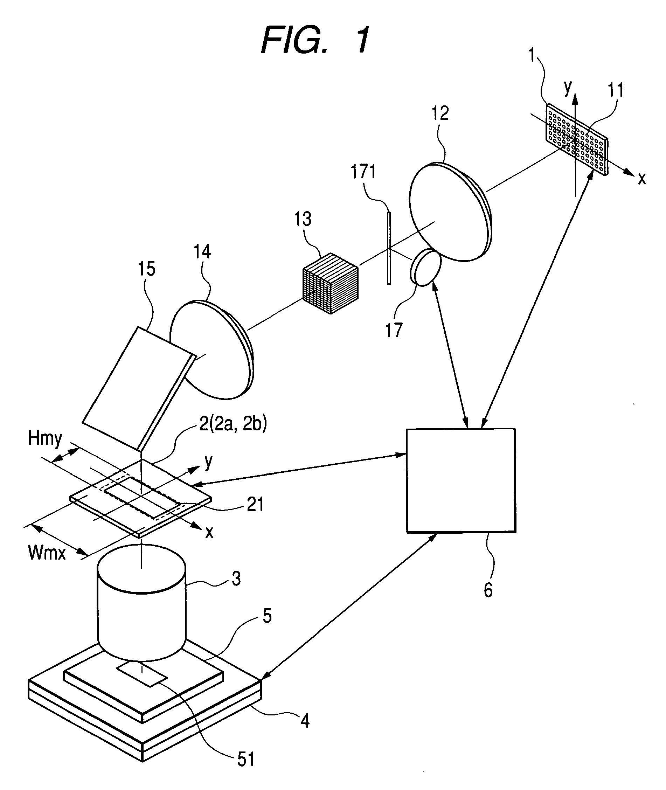

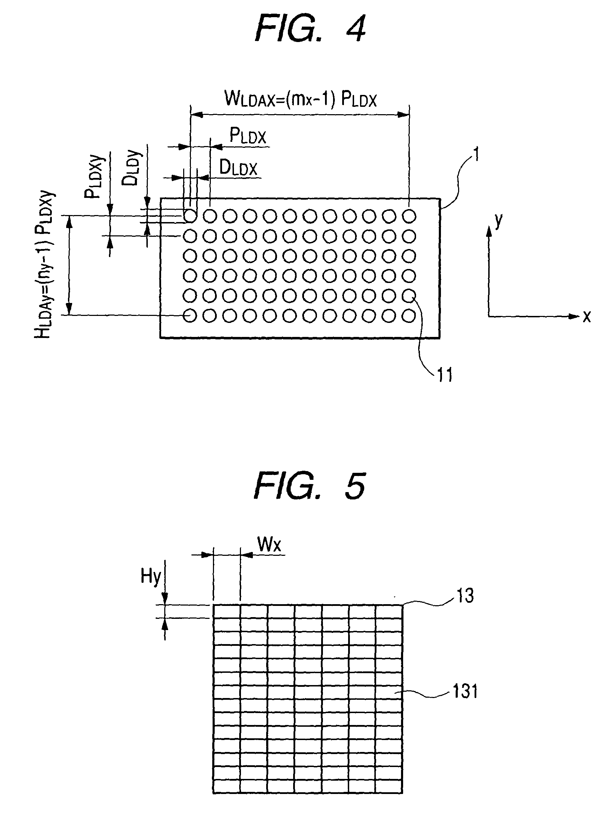

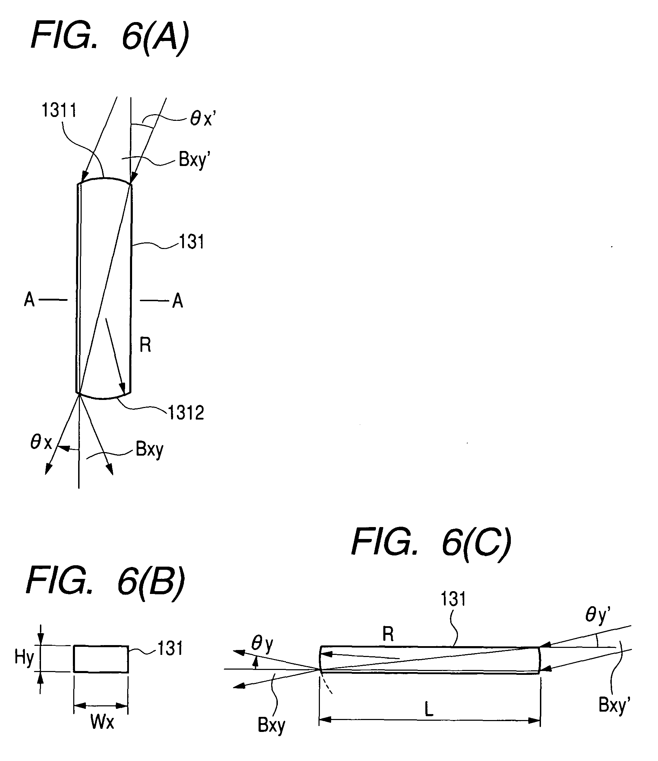

First, a first embodiment of an exposure apparatus according to the present invention is described below using FIG. 1. An LD array 1 is a light source array formed of a one-dimensional or two-dimensional arrangement of a plurality of separate light sources. The LD array 1 is constructed by arranging, two-dimensionally on a substrate, blue (purple) semiconductor lasers 11 from each of which the light having a wavelength of nearly 405 nm (380 to 420 nm) is emitted with an output of about 30 mW. The outgoing light from the individual semiconductor lasers 11 passes through a condenser (condensing optics) 12 and then enters a light integrator 13 later detailed using FIG. 5 and FIGS. 6(A) to 6(C). The light that has passed through the light integrator 13 passes through a condenser lens (collimating lens) 14, which is an irradiation optical means, and is reflected by a mirror 15 and directed onto a mask 2. The mask 2 may be a normal chromium or chromium-oxide mask 2a or may be, for example, a two-dimensional light modulator 2b having a mask function, such as a liquid-crystal or digital mirror device, etc.. The light integrator 13 is optical system which, after the outgoing light fluxes from the large number of two-dimensionally arranged semiconductor lasers 11 have been condensed by the condenser lens (condensing optical system) 12, spatially decomposes the outgoing light, generates a great number of pseudo-secondary light sources, and overlaps an output of each pseudo-secondary light source to conduct illumination.

Light that has passed through or reflected from a pattern display unit 21 (for example, formed into a rectangular shape) of the mask 2a or two-dimensional light modulator 2b is projected via a projection lens 3 to expose patterns 21 present on an exposure area 51 of an exposure target substrate 5 to the light. When the substrate 5 is moved by a substrate movement mechanism 4 which includes a substrate chuck and an xy stage, the patterns are exposed, one after another, over a desired area on the substrate 5. When the normal mask 2a is used, the patterns drawn on the mask will be repeatedly exposed. When the two-dimensional light modulator 2b is used alternatively, one set or several sets of desired patterns will be exposed over almost the entire surface of the substrate 5.

A control circuit 6 controls the semiconductor lasers 11 to activate them in the timing of each exposure and to deactivate them upon completion of a desired amount of light exposure of the substrate 5. That is to say, the control circuit 6 acquires about 1% of the light incident on a beam splitter 171 provided within an optical path, into a photodetector 17. The intensity of the light that has been detected by the photodetector 17 is integrated by the control circuit 6. The value thus integrated becomes an integrated amount of exposure of the exposure illumination light to which the substrate 5 is to be exposed. When this value reaches the desired setting value (optimum exposure amount) stored into the control circuit 6 beforehand, therefore, the control circuit 6 turns off the semiconductor lasers 11 to complete the exposure.

In accordance with display two-dimensional pattern information of the two-dimensional light modulator 2b, the control circuit 6 also sends a signal for controlling operations of the two-dimensional light modulator 2b. In addition, the control circuit 6 drives the substrate movement mechanism 4 to move the substrate 5 while synchronizing it with the display two-dimensional pattern information of the two-dimensional light modulator 2b so that desired patterns are exposed over nearly the entire surface of the substrate on the substrate 5.

When performing scanning exposures on the substrate 5 by continuously moving the stage 4, the control circuit 6 controls a scanning speed of the stage in accordance with signal intensity of the photodetector 17 monitoring the above exposures. Additionally, when the two-dimensional light modulator 2b is used, the control circuit 6 totally controls operations of the two-dimensional light modulator 2b, a signal of the photodetector 17, and a driving signal of the stage.

Since the multiple semiconductor lasers 11 can be individually turned on-off, outputs of the individual lasers can be sequentially monitored using the photodetector 17 shown in FIG. 1. Therefore, the control circuit 6 sends a blinking signal to each LD 11 in order and detects the signal intensity of the photodetector 17 synchronously with the signal, whereby the control circuit 6 can detect a decrease in output, associated with deterioration of the LD 11. Accordingly, the control circuit 6 controls energy of each light source by increasing an electric current to a certain value so that when an output of the laser decreases, the output may stay within a desired constant value. In other words, the control circuit 6 controls the energy of the light outgoing from each of the great number of light sources 11 so that the energy of each light source 11 may stay within the desired constant value. By doing so, it becomes possible to obtain uniformity of the illumination light and to maintain constant intensity thereof.

The multiple semiconductor lasers 11 shown in FIG. 1 are arranged in an equal-pitch uniform density distribution. In addition, the area where the light sources 11 are arranged is formed as a region analogous to a shape of the illumination target region 21 which is the pattern display unit of the mask 2a or the two-dimensional light modulator 2b. Of course, if the region 21 to be illuminated is of a rectangular shape, the arrangement area of the light sources 11 is an analogous, rectangular region.

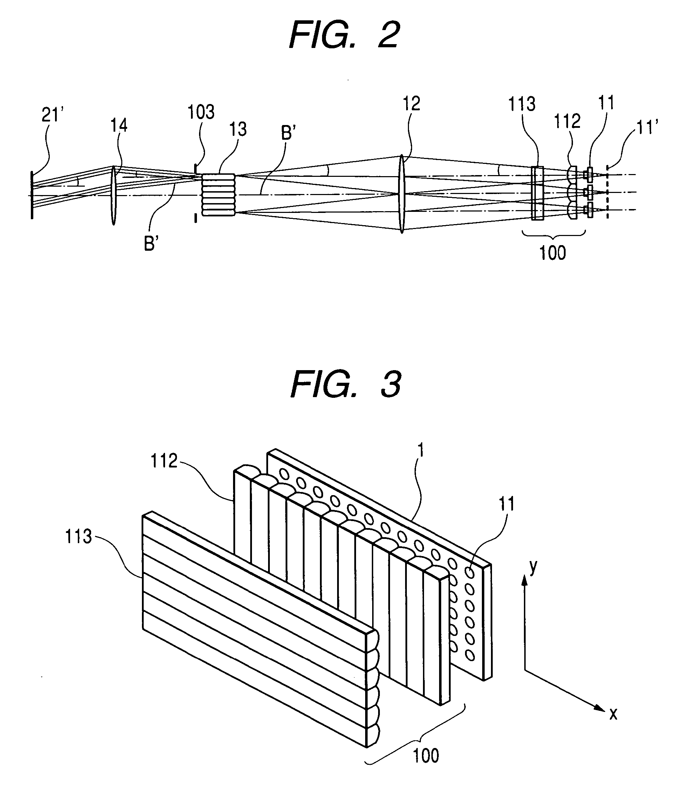

The semiconductor lasers 11 usually vary in spread angle of their outgoing light, depending on whether the spread angle faces in the direction shown on the paper of FIG. 2 (i.e., an x-direction) or in a direction perpendicular to that shown on the paper (i.e., a y-direction). In the directions of the locations where, for example, half value is given to maximum value, the spread angle of the outgoing light of each semiconductor laser 11 in the direction shown on the paper of FIG. 2 (i.e., the x-direction) is about 28 degrees when measured from an optical axis, and the spread angle in a direction perpendicular to that shown on the paper (i.e., the y-direction) is about 8 degrees. The spread angles in both directions (the x-direction and the y-direction), therefore, need to be almost equaled or to be controlled to stay within the maximum value of 1.5 times that does not cause any trouble. By doing so, as described later, an intensity distribution of the light entering from each semiconductor laser to the light integrator 13 can be made almost equal in terms of rotational symmetry.

Consequently, as described later, an intensity distribution of the incident light of the light integrator 13 equals an intensity distribution of the light going out therefrom. In addition, an exit position of the light integrator takes an image-forming relationship with an incident pupil of the projection exposure lens 3. Therefore, the exposure illumination that forms a rotationally symmetric intensity distribution on the pupil of the projection exposure lens 3 is realized. A rotationally symmetric intensity distribution is formed on the pupil of the projection exposure lens 3 in this manner. Thus, the almost equal directivity of illumination that does not depend on the direction of the pattern on the mask 2a or two-dimensional light modulator 2b can be obtained. As a result, image-resolving characteristics not depending on the direction of the pattern is obtained and the substrate surface is accurately exposed without distortion. Reference numeral 103 denotes a field stop provided at the exit position of the light integrator.

As described above, by forming imaginary images of the semiconductor laser (LD) light sources at a position of reference numeral 11', the cylindrical lenses 112 shown in FIG. 2 cause light to look as if it had been exited from a point light source of 11'. Consequently, the laser beams that had a spread angle of about 28 degrees from respective optical axes on the paper (x-direction) when emitted from the LDs, are narrowed to a spread angle of about one degree. Similarly, by forming the imaginary images of the LD light sources at nearly the position of reference numeral 11', the cylindrical lenses 113 arranged vertically on the paper make the light as if it had been exited from the point light source of 11'. Consequently, the laser beams that had a spread angle of about 8 degrees from respective optical axes on the paper (y-direction) when emitted from the LDs, are narrowed to a spread angle of about one degree. Thus, for any of the outgoing laser beams from the LDs 11, an almost rotationally symmetric intensity distribution is achieved by the cylindrical lenses 112 and 113. That is to say, the beam divergence angle is adjusted in the cylindrical lens optics 100 so that the divergence angle of the light emitted from the secondary light sources 11' may stay within a rate of 1 versus 1.5 with respect to any two directions (e.g., the x-direction and the y-direction) within a plane vertical to the optical axis of the emitted light. Thus, the outgoing light from the light sources can be effectively used as illumination light at the plane of incidence of the light integrator 13 usually having a circular effective diameter. Consequently, as described above, a rotationally symmetric intensity distribution can be obtained on the pupil of the projection exposure lens 3 and thus the pattern displayed by the mask 2a or the two-dimensional light modulator 2b can be exposed accurately.

Beam divergence angle adjustments can be performed by arranging, as shown in FIG. 3, two kinds of cylindrical lenses 112, 113 whose focal lengths differ according to the divergence angle between the two orthogonal axes of the LDs, longitudinally along the optical path.

The element 13 shown in FIG. 2 is a light integrator, and FIG. 5 is a view of the light integrator 13 as viewed from an optical-axis direction. The light integrator 13 can be broadly divided into a glass-rod type and a lens-array type. If the light integrator 13 is of the glass-rod type, it is formed of multiple rod lenses 131. Each rod lens 131 has the structure shown in FIGS. 6(A) to 6(C). An end face 1311 on the incident side is a convex spherical face, and an end face 1312 at the exit side is also a convex spherical face. If radii of curvature of both convex faces are taken as R, and a refractive index of the rod lens glass as "n", length L of the rod lens is expressed as $nR/(n-1)$. The beam components Bxy' incident at an angle of θx' with respect to the optical axis, as shown in FIG. 6(A), are dimensionally narrowed at the exit end face by an effect of the convex spherical lens at the incident face 1311. After being further narrowed, the beams Bxy' going out from the exit end 1312 all become, by an effect of the convex spherical lens at the exit face, the outgoing light that does not depend on the incident angle θx' and has principal rays parallel to the optical axis (parallel to the axis of the rod lens).

As mentioned above, the outgoing laser beams from the imaginary image position of 11' that were narrowed to a spread angle of about one degree by the cylindrical lenses 112 and 113 enter the condenser lens 12. A front focal point of the condenser lens 12 is present at the imaginary image position of 11', and a back focal point, at the incident end of the light integrator. Therefore, after passing through the condenser lens 12, the outgoing laser light from each LD 11 enters the light integrator 13 as parallel beams, and the incident angles ($\theta$x', $\theta$y') of the incident beam components Bxy' at the incident end of the above-mentioned rod lens 131, with respect to the light integrator 13, are associated with the arrangement positions (x, y) of the semiconductor lasers 11, shown in FIG. 4. That is, the LD array 1 is, for example, an array of LDs 11 as shown FIG. 4. In this array, when an x-directional diameter of one LD is taken as $D_{LDx}$, a y-directional diameter as $D_{LDy}$, an x-directional pitch as $P_{LDx}$, a y-directional pitch as $P_{LDy}$, the number of LDs in the x-direction, as "$m_x$", and the number of LDs in the y-direction, as "$n_y$", x-directional length $W_{LDAx}$ and y-directional length $H_{LDAy}$ can be represented by expressions (1) and (2) shown below.

$$W_{LDAx} = (m_x - 1)P_{LDx} \qquad (1)$$

$$H_{LDAy} = (ny - 1)P_{LDy} \qquad (2)$$

In this way, by using the condenser lens (collimating lens) 12 to associate the pitches ($P_{LDx}$, $P_{LDy}$) of the LDs 11 with the pitches (Wx, Hy) of the rod lenses 131 constituting the light integrator 13, each outgoing ray from the secondary light sources 11' is allowed to enter the same position on the light integrator 13. This makes it possible to realize illumination uniform not depending on any illumination location and uniform in directivity.

The beams B' emitted from each LD 11 onto the light integrator 13 in this fashion become parallel beams and take an almost rotationally symmetric Gaussian distribution having a center at the center of the plane-of-incidence (i.e., optical axis) of the light integrator 13. Since the light integrator 13 is a set formed of a large number of rod lenses 131, the light incident on one rod lens 131 forms a very small portion of the Gaussian distribution. For this reason, almost uniform intensity is achieved within one rod lens 131. In addition, a position of the rod lens incident light at the incident end face 1311 thereof and an exit direction of the outgoing light are associated with each other. As a result, the outgoing light almost equals in terms of the light intensity at whichever spread angle with the optical axis as its center. In addition, since the spread angle is associated with a location of a face of the mask 2a or of a modulation face of the two-dimensional light modulator 2b via the collimating lens 14, the face of the mask 2a or the modulation face of the two-dimensional light modulator 2b is uniformly illuminated, independently of the particular location.

Furthermore, each rod lens in section has widths of Wx, Hy in the x- and y-directions, as shown in FIG. 6(B). Since, as mentioned above, the position of the incident light at the rod lens end 1311 and the exit angle ($\theta$x, $\theta$y) of the outgoing light are associated with, i.e., proportional to each other, maximum spread angle $\theta$xm, $\theta$ym of the outgoing light (an angle range of the outgoing light from the optical axis) is in proportion to the sectional size (Wx, Hy) of the rod lens. That is, in more strict terms, a relationship of expressions (3) and (4) shown below is established, in which "n" denotes the refractive index of the rod lens glass and L denotes the length of the rod lens.

$$\theta xm = nWx/2L \qquad (3)$$

$$\theta ym = nHy/2L \qquad (4)$$

The light integrator exit face 1312 and the mask 2a or the two-dimensional light modulator 2b serve as the front focal plane and back focal plane, respectively, of the collimating lens 14 having a focal length of "fc"; therefore, the coordinate ranges Wmx and Hmy of the beam (x, y) emitted onto the mask 2a or the two-dimensional light modulator 2b are given by expressions (5) and (6) shown below.

$$Wmx = fc \cdot \theta xm = Wx \cdot nfc/2L \qquad (5)$$

$$Hmy = fc \cdot \theta ym = Hy \cdot nfc/2L \qquad (6)$$

In short, only a necessary portion of the mask 2a or the two-dimensional light modulator 2b can be exposed to uniform light by assigning 1 as a ratio "$r_1/r_0$" between an aspect ratio "$r_1$" (= Wx/Hy) of the sectional shape of each rod lens that is perpendicular to the optical axis, and an aspect ratio "$r_0$" (= Wmx/Hmy) of the region to be illuminated (21). Compared with the value obtained using a conventional method of exposure illumination, sufficiently valid light utilization efficiency is realized, provided that the above ratio "$r_1/r_0$" is 0.8 or more, but up to 1.2.

If the light integrator 13 is of the lens-array type, it is formed of two lens arrays, i.e., a first lens array closer to the light sources and a second lens array more distant therefrom. On the first lens array, lens cells are two-dimensionally arranged to spatially split the light fluxes obtained from the LD array 1. Each lens cell on the first lens array is adapted to condense a flux onto each of associated cells of the second lens array, on which are then formed secondary light source images as many as there actually are split fluxes. Each lens cell on the second lens array activates an aperture of each associated lens cell on the first lens array to form an image on a plane of the region 21 to be illuminated. The condenser lens 14 is adapted to align a center of each lens cell with that of the region 21 to be illuminated, and thus to ensure that each lens cell on the first lens array overlaps in the region 21 to be illuminated. Consequently, similarly to those of the glass-rod type, the illumination light fluxes distributed in an almost rotationally symmetric fashion have their intensity integrated, and respective intensity differences are offset, whereby a uniform intensity distribution can be obtained.

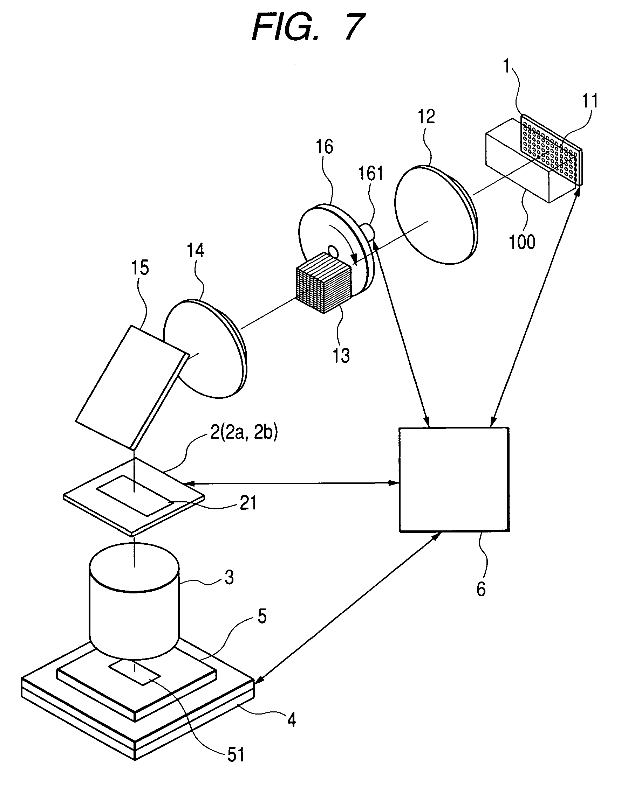

Next, a second embodiment of an exposure apparatus according to the present invention is described below using FIG. 7. In FIG. 7, the same optical component number as that of FIG. 1 denotes the same element. The second embodiment is different from the first embodiment in that it includes a diffuser 16, which is a modulator adapted to change wavefronts. The diffuser 16 is operative to prevent the occurrence of interference fringes by making illumination light almost completely uniform, independently of spatial frequencies. With this configuration, outgoing light from each of LD light sources 11 is made to pass through the cylindrical lens optics formed of cylindrical lenses 112 and 113, and through a condenser lens 12, and then pass through the diffuser 16 before entering a light integrator 13 as the parallel beams B' having nearly a rotationally symmetric intensity distribution.

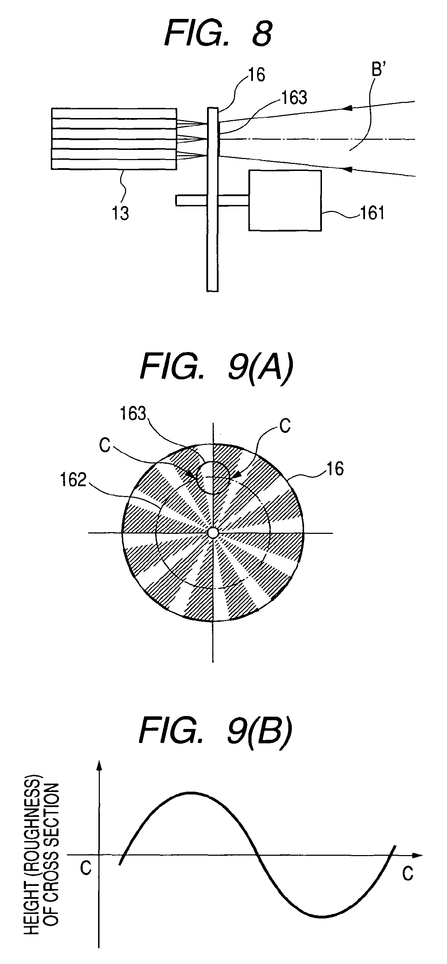

The diffuser 16 is a modulator adapted to change wavefronts, and as shown in, for example, FIG. 8, the diffuser is constructed of a glass disc 16, which is rotated by rotational driving of a directly connected motor 161. The glass disc 16 is optically polished in a radial form. The glass surface of section C-C in FIG. 9(A) varies in height in nearly a sinusoidal fashion as shown in FIG. 9(B). This variation in height (roughness) is several microns. By the way, reference numeral 163 denotes the beam of light that enters the diffuser 16, and reference numeral 162 denotes a central rotation path of the beam 163 on the diffuser 16.

One period of length is determined by a rotating speed of the disc 16 and an exposure time. A change of about one period occurs on an exposure optical axis during nearly one step of exposure. When a scanning exposure is conducted, a change of about one to several periods occurs during movement through one picture element of distance. These rotating speeds are controlled by a control circuit 6 in synchronization with display control of a two-dimensional light modulator 2b and movement control of a stage 4. Once the disc has started to rotate, however, it rotates at either of the fixed speeds mentioned above. Consequently, by varying nonuniform, high spatial-frequency components of the illumination light for a mask 2a or for the two-dimensional light modulator 2b and then averaging the light on a time basis, almost completely uniform illumination light not depending on spatial frequencies can be realized to prevent interference fringes from occurring. Although the modulator 16 adapted to vary wavefronts, shown in FIG. 7, is installed in immediate front of the light integrator 13, a similar effect is also obtainable by installing the modulator 16 at immediate rear of the light integrator 13.

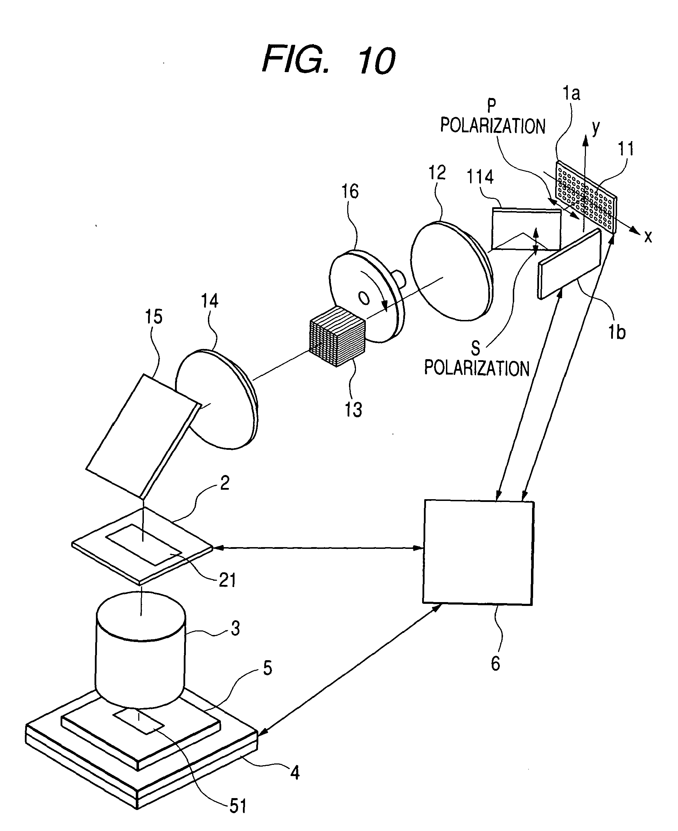

Next, a third embodiment of an exposure apparatus according to the present invention is described below using FIG. 10. The third embodiment is different from the first and second embodiments in that multiple LD arrays are installed for an increased amount of exposure light. Since outgoing light from semiconductor lasers 11 is linearly polarized light, LDs 11 are installed in a direction-corrected form such that all outgoing light from, for instance, an N number of LD arrays 1a is light linearly polarized in an x-direction. Likewise, the LDs 11 are installed in a direction-corrected form such that all outgoing light from an N number of LD arrays 1b is light linearly polarized in a γ-direction. The x-directional, linearly polarized light going out from the LD arrays 1a is nearly 100% passed through a polarization beam splitter 114, thus becoming P-polarized light. The y-directional, linearly polarized light going out from the LD arrays 1b is nearly 100% reflected by the polarization beam splitter 114, thus becoming S-polarized light. As a result, laser light from the 2N number of LDs 11 is all introduced into exposure optics without a loss.

In the above description, the LD arrays 1b are installed so that the light in the y-direction may be linearly polarized light. However, as with the LD arrays 1a, the LD arrays 1b can be installed so that the light in the x-direction may be linearly polarized light. In this case, a 1/2 wavelength plate may be installed halfway on an optical path of the light from the position where it emitted from the LD arrays 1b, to the position where it enters the polarization beam splitter 114, such that the light after passing through the 1/2 wavelength plate is linearly polarized in the y-direction.

Although a semiconductor laser, namely, an LD is usually enclosed in a small pipe having a transparent window, the quantity of two-dimensional arrangement is limited since this pipe is as small as slightly short of only about 6 mm in diameter. According to the present third embodiment, therefore, the effect that the quantitative limit can be increased by providing multiple LD arrays is obtained.

Laser light that has passed through the polarization beam splitter 114 contains components of the light polarized in two orthogonal directions, passes through a condenser 12, a light integrator 13, a collimator lens 14, a mask 2 or a two-dimensional light modulator 2, and a projection exposure lens 3, and arrives at a substrate 5. These components arranged halfway on the optical path transmit laser light, independently of polarization, and the light can be directed to the substrate at twice an exposure rate. This results in an exposure time being reduced to 1/2 and thus in a higher throughput being achievable.

A two-dimensional light modulator 2b is driven (operated) in accordance with the information sent from a control circuit 6 about the pattern to be exposed, and in synchronization with the driving (operating) information, a stage 2 and the LD arrays 1a and 1b are driven. When the LDs 11 are driven from the control circuit 6, an LD turn-on time is controlled so that exposure light may be optimized for a sensitivity of the substrate 5, and the LDs go out in the timing that no exposures are conducted.

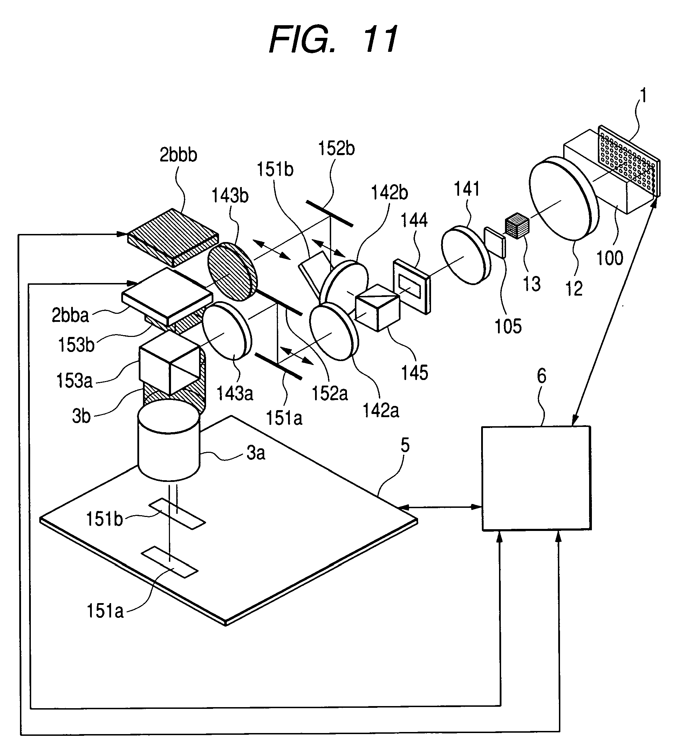

Next, a fourth embodiment of an exposure apparatus according to the present invention is described below using FIG. 11. The fourth embodiment is different from the first to third embodiments in that two-dimensional light modulators 2b of the reflection type, not of the transmission type, are used as masks 2. In short, the two-dimensional light modulators 2b can be of either the transmission type or the reflection type. Two-dimensional light modulators 2bb of the reflection type, such as reflection-type liquid-crystal two-dimensional light modulators, are used in the fourth embodiment. A laser beam that has been emitted from an LD light source 1 is split into two segments by a beam splitter 145 and introduced into two sets of exposure optics. Reference numeral 144 denotes a field stop having a conjugate relationship in position with respect to display units of the two-dimensional light modulators. An image of this field stop is formed on display units of two-dimensional light modulators 2bba and 2bbb via lens sets 142a, 143a and 142b, 143b, and these display units are imaged on exposure regions 151a and 151b of a substrate 5.

Light that has been emitted from semiconductor lasers 11 is linearly polarized light parallel to a surface of the substrate in the figure, i.e., to a horizontal plane. After passing through a light integrator 13, therefore, the light is circularly polarized by a 1/4 wavelength plate 105. Since the beam splitter 145 is a polarization beam splitter, P-polarized light components that are horizontally polarized components of the circularly polarized light incident on the polarization beam splitter 145 pass therethrough and S-polarized light reflects from the polarization beam splitter 145. The S-polarized light that has reflected is light polarized linearly in a vertical direction, and the light reflects from mirrors 151b and 152b, becoming the light polarized linearly in a horizontal direction.

The two exposure beams thus generated by branching at the polarization beam splitter 145 both enter polarization beam splitters 153a and 153b as the light polarized linearly in a horizontal direction. To the polarization beam splitters 153a and 153b, incident light is S-polarized light. Therefore, the light is 100% reflected and enters vertically the two-dimensional light modulators 2bba and 2bbb each formed of a reflection-type liquid crystal. When the voltage to be applied to each of display picture elements of the reflection-type liquid-crystal two-dimensional light modulators 2bba and 2bbb is turned on/off according to particular display information, polarization of the reflected light correspondingly changes intact or at right angles. When the reflected light is passed through the polarization beam splitters 153a and 153b once again, only the picture elements where the polarized light has changed at right angles pass through the beam splitters 153a and 153b.

The thus-obtained two-dimensional light information is imaged and projected as an exposed pattern on elements 151a and 152b of the substrate 5 by projection exposure lenses 3a and 3b.

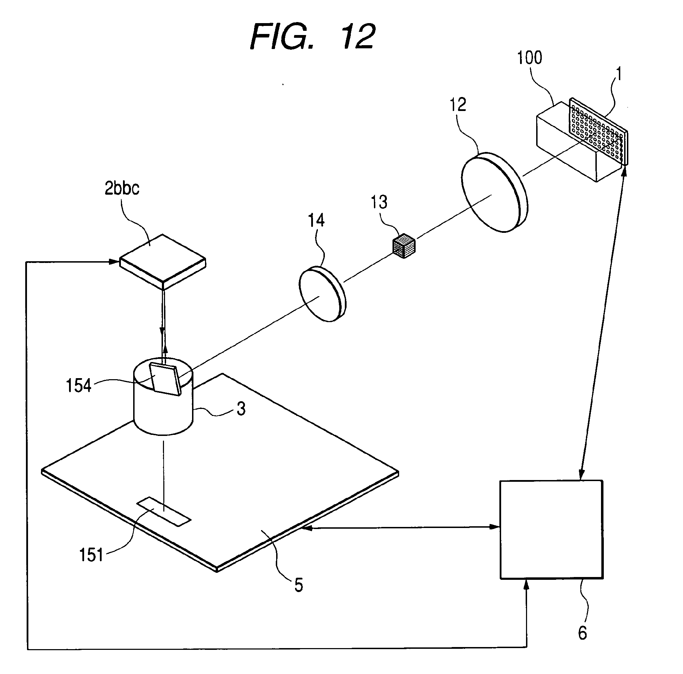

Next, a fifth embodiment of an exposure apparatus according to the present invention is described below using FIG. 12. The fifth embodiment uses a digital mirror device 2bbc as a reflection-type two-dimensional light modulator. The digital mirror device 2bbc is constructed by providing individual picture elements with the membrane mirrors that are driven by electrical signals. The exposure light applied onto each mirror inclines the mirror only through an angle of θ at the section where the signal turns on, and does not make the mirror incline at the section where the signal turns off. For example, exposure light is emitted in a state reflected by a mirror 154, and the light that has been reflected by the inclined mirror enters a projection exposure lens 3 and passes through the lens 3. On the other hand, for the picture elements for which the mirror does not tilt, light does not pass through the projection exposure lens 3 since the light undergoes regular reflection and deviates from a pupil of the lens 3. As a result, a pattern displayed on the digital mirror device 2bbc by use of a digital mirror device driving signal will be projected for exposure, on a substrate 5, by the projection exposure lens 3.

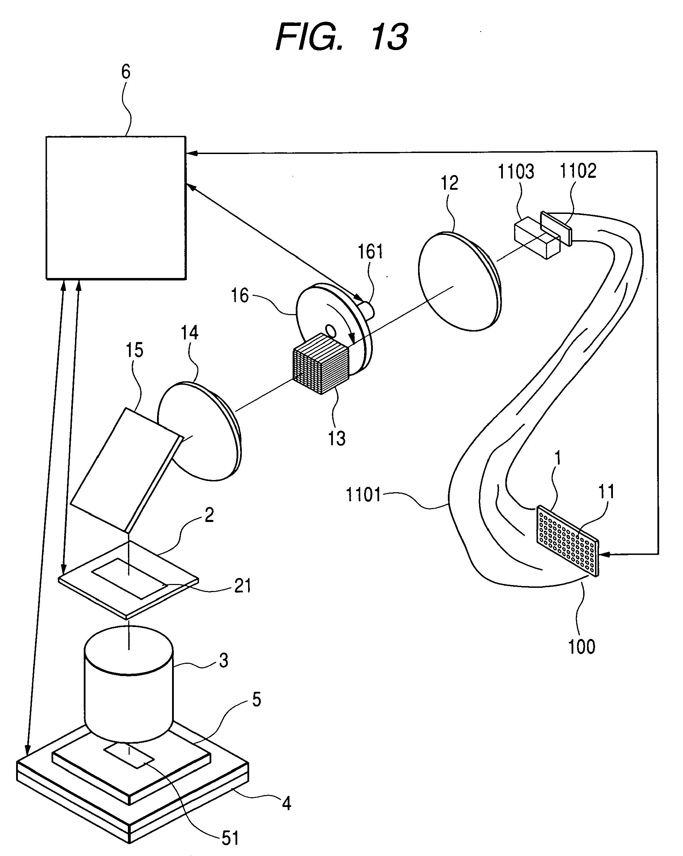

Next, a sixth embodiment of an exposure apparatus according to the present invention is described below using FIG. 13. The sixth embodiment is constructed so that the light emitted from multiple semiconductor lasers 11 provided as a light source array 1 is first received via photoconductor optical system not shown, such as lenses, then introduced via optical fibers 1101, and exits from an exit end 1102 which serves as a secondary light source. The light, after exiting from each fiber end of the optical fibers 1101, goes through beam-shaping optical system 1103 with a desired spread angle. The exit end 1102 that serves as a secondary light source has a light-emitting region almost analogous to a display region 21 of a two-dimensional light modulator 2b. Constructing the exposure apparatus in this way ensures that as already described, the light that has emitted from the secondary light source illuminates the two-dimensional light modulator 2b efficiently and uniformly.

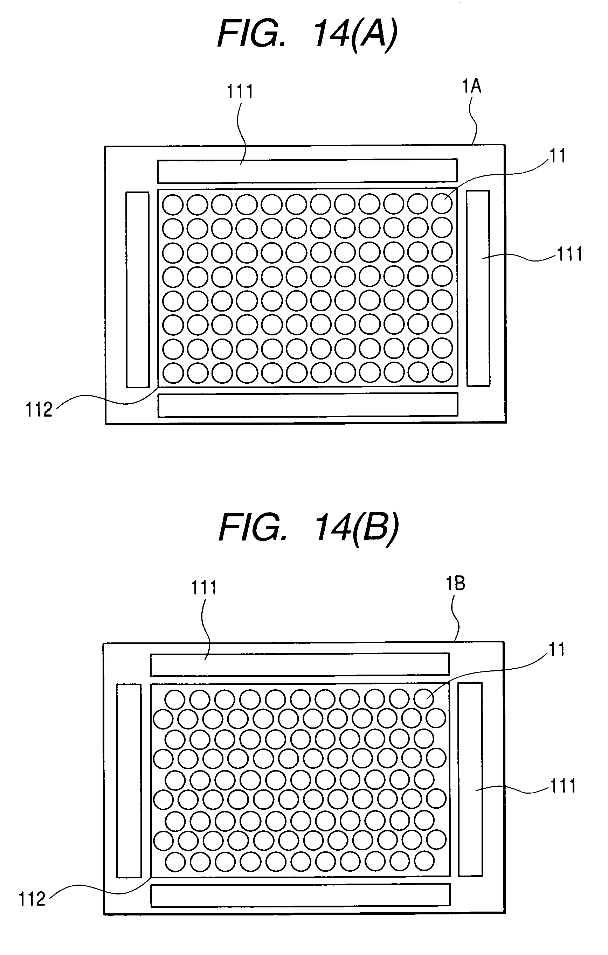

Next, embodiments of the LD arrays that are light source arrays according to the present invention are described in detail below using FIGS. 14(A) and 14(B). In these embodiments of the LD arrays, the LD array 1A shown in FIG. 14 (A) is as described heretofore, with LDs being arranged as the LD array at equal pitches in x- and y-directions. The LD array 1B shown in FIG. 14(B), however, is a most densely packaged array. That is to say, LDs 11 are arranged at an apex of an equilateral triangle. In this embodiment, if an arrangement pitch is taken as P for an outside diameter D of a circle of the LD package, P can be set to a range, for instance, from 1.07 to 1.10 D. The elements 112 in FIGS. 14(A) and 14(B) are mutually congruent rectangles each depicting an LD-packaging region. The most densely packaged array in FIG. 14(B) is higher in packaging density. More specific data evaluations indicate that whereas an LD-packaging density of the LD array 1A is $1/P^2$, that of the LD array 1B is $1.154/P^2$, and this means that it is possible to enhance the packaging density, i.e., to increase an output of the light source by about 15%.

The elements 111 shown in FIGS. 14(A) and 14(B) are coolers for maximizing lives of the large number of arranged LDs by preventing each LD from being heated by the heat stemming therefrom. More specifically, the coolers 111 can be constructed of a material having high thermal conductivity, such as copper, and provision of through-holes in this material and supply of cooling water therethrough allows driving at 25°C or less. Use of a Peltier element likewise allows cooling to 25°C or less, thus making long-life operation achievable.

The present invention is not limited to or by the above-described embodiments of the LD arrays. In other words, the present invention can likewise be embodied by using a light source relatively high in directivity, for example, a light-emitting diode (LED) or any other small lamp having a smaller light-emitting area, as a light source. Alternatively, the present invention can likewise be embodied by using multiple laser light sources other than semiconductor lasers.

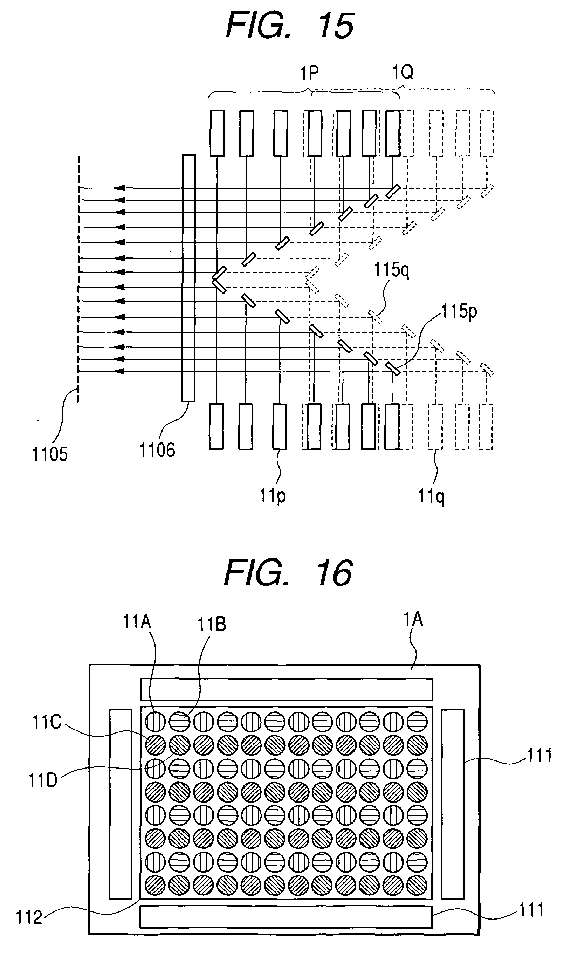

Next, a further embodiment of a light source array according to the present invention is described below using FIG. 15. A light source array 1 uses normal gas laser light sources or solid-state laser light sources each having a relative small divergence angle. The laser light sources themselves, however, are not arranged two-dimensionally. That is to say, there is no need to emit laser light in the same direction, from any laser. For a large laser cross-sectional area in an optical-axis direction, densities of multiple beams can be increased above a mounting density of the lasers by, as shown in FIG. 15, folding back an optical path by use of mirrors 115p and 115q.

A solid-line section (1P) in FIG. 15 denotes the array of laser light sources 11p when drawn in section on the paper. In addition, a dotted line (1Q) denotes the array of laser light sources 11q located at fixed intervals in parallel to the paper and when drawn in section. Actually, three or more such sections are present. The beams that have been folded back by the mirrors 115p, 115q, and the like, proceed to the left side of the figure, taking a two-dimensional distribution. Reference numeral 1106 denotes microlenses, and an optical axis of each microlens is aligned with a center of each beam. Light that has passed through the microlenses 1106 has the respective beams condensed onto a secondary light source surface 1105. This secondary light source surface 1105 is disposed so as to match the front focal plane of the condenser 12 shown in FIG. 1, 2, 7, 10, 11, or 12.

Also, illumination containing various wavelengths can be obtained by simultaneously arranging multiple kinds of light sources. Such illumination including light beams of various wavelengths can also be used in applications other than light exposure, and in this case, uniform illumination high in the utilization efficiency of light can also be implemented. The illumination usable in such applications includes that used for purposes such as observing and/or inspecting microstructured patterns using, for example, a microscope.

When the LEDs or LDs having multiple wavelengths are to be used as a light source array 1A, the exposure apparatus is constructed as shown in FIG. 1, 2, 3, 4, or 14. The multiple light sources 11 include, as shown in FIG. 16, for example, multiple kinds of light sources 11A, 11B, 11C, and 11D, each having a different wavelength. When multiple kinds of light sources are used in multiple numbers for each kind in this way, the light sources of each kind are desirably arranged so as to distribute uniformly as shown in FIG. 16.

While the above-described light source arrays are two-dimensional arrays of separate multiple light sources, it is obvious that when the illumination region is elongate, the light sources can be arranged one-dimensionally.

In addition, according to the embodiments described above, it becomes possible to arrange a large number of semiconductor lasers and use outgoing light efficiently as illumination light, and to use input electrical energy effectively for light exposure of a substrate, compared with the use of conventional mercury lamps as the light sources. A contribution can therefore be made to energy savings. Additionally, it has become possible to use solid-state light sources, to achieve life extension of light sources, and to facilitate maintenance.

Industrial Applicability

According to the present invention, energy-saving and high-performance illumination has been realized by irradiating high-efficiently and uniformly the object to be irradiated, by use of the multiple light sources, such as semiconductor lasers, that have small light-emitting energy per unit.

In addition, according to the present invention, by realizing energy-saving and high-performance illumination, high-throughput and high-performance light exposure of patterns can be achieved when exposure of the patterns on a substrate or the like.

**Claims**

1. A method of illumination, comprising the steps of:

   emitting light from each of a plurality of light sources separately arranged in a one-dimensional or two-dimensional form;
   spatially decomposing via a light integrator the light emitted from each of the plurality of light sources, and thus generating a multitude of pseudo-secondary light sources; and
   overlapping via a condenser lens the light emitted from the multitude of generated pseudo-secondary light sources, and thus illuminating a region to be illuminated.

2. The method of illumination according to claim 1,
   wherein a region in which the plurality of light sources are arranged, or a light-emitting region of the secondary light sources obtained from the plurality of light sources is made analogous to a shape of the region to be illuminated.

3. The method of illumination according to claim 1,
   wherein the light sources are semiconductor laser light sources.

4. The method of illumination according to claim 1,
   wherein the light integrator comprises an array of a plurality of rod lenses; and
   wherein a ratio "$r_1/r_0$" between an aspect ratio "$r_1$" of the sectional shape of each rod lens that is perpendicular to an optical axis thereof, and an aspect ratio "$r_0$" of the region to be illuminated, is 0.8 or more and 1.2 or less.

5. The method of illumination according to claim 1,
   wherein the light entering the light integrator or the light exiting the light integrator passes through a modulator which varies wavefronts.

6. The method of illumination according to claim 1,
   wherein a divergence angle in the light flux emitted from each of the plurality of light sources is adjusted to stay within a ratio of 1 versus 1.5 with respect to any two directions within a plane vertical to an optical axis of the emitted light flux.

7. The method of illumination according to claim 1,
   wherein energy of the light emitted from the light sources is controlled.

8. The method of illumination according to claim 1,
   wherein each light ray emitted from the plurality of light sources or from secondary light sources is caused to enter an associated position on the light integrator via condensing optical system.

9. A method of illumination, wherein light emitted from each of a plurality of light sources separately arranged in a one-dimensional or two-dimensional form is applied onto an illumination target region so that at least 30% of energy of the light emitted from each of the light sources arrives at the illumination target region without overstepping an illuminance nonuniformity range of $\pm$10% in the illumination target region.

10. A method of light exposure, comprising the steps of:

   emitting light from each of a plurality of light sources separately arranged in a one-dimensional or two-dimensional form;

spatially decomposing via a light integrator the light emitted from each of the plural light sources, and thus generating a multitude of pseudo-secondary light sources; and

overlapping via a condenser lens the light emitted from the multitude of generated pseudo-secondary light sources, and thus illuminating an illumination target region having a pattern to be exposed;

wherein the illuminated pattern to be exposed is exposed by projecting transmitted or reflected light onto an exposure target region of an exposure target object via projection optical system.

11. The method of light exposure according to claim 10, said method being **characterized in that** a region in which the plurality of light sources are arranged, or a light-emitting region of the secondary light sources obtained from the plurality of light sources is made analogous to a shape of the region to be illuminated.

12. The method of light exposure according to claim 10, wherein the light sources are semiconductor lasers light sources.

13. The method of light exposure according to claim 10, wherein the light integrator comprises an array of a plurality of rod lenses; and
wherein a ratio "$r_1/r_0$" between an aspect ratio "$r_1$" of the sectional shape of each rod lens that is perpendicular to an optical axis thereof, and an aspect ratio "$r_0$" of the region to be illuminated, is 0.8 or more and 1.2 or less.

14. The method of light exposure according to claim 10, wherein the light entering the light integrator or the light exiting the light integrator passes through a modulator which varies wavefronts.

15. A light exposure apparatus comprising:

an illumination optical system including:

a light source array formed of a plural separate light sources arranged one-dimensionally or two-dimensionally;
a condensing optical system for condensing light emitted from each light source of said light source array;
a light integrator for spatially decomposing the light condensed by said condensing optical system, and thus generating a multitude of pseudo-secondary light sources; and
a condenser lens for overlapping the light rays emitted from the multitude of pseudo-secondary light sources generated by said light integrator, and thus illuminating an illumination target region having a pattern to be exposed; and

a projection optical system for projecting transmitted or reflected light onto an exposure target region of an exposure target object in order to expose the pattern to be exposed that is illuminated by said illumination optical system.

16. The light exposure apparatus according to claim 15, wherein in said illumination optical system, a region in which the plurality of light sources are arranged, or a light-emitting region of the secondary light sources obtained from the plurality of light sources is made analogous to a shape of the region to be illuminated.

17. The light exposure apparatus according to claim 15, wherein in said light source array of said illumination optical system, the light sources are semiconductor lasers light sources.

18. The light exposure apparatus according to claim 15, wherein said light integrator of said illumination optical system comprises an array of a plurality of rod lenses and is adapted such that a ratio "$r_1/r_0$" between an aspect ratio "$r_1$" of the sectional shape of each rod lens that is perpendicular to an optical axis thereof, and an aspect ratio "$r_0$" of the region to be illuminated, is 0.8 or more and 1.2 or less.

19. The light exposure apparatus according to claim 15, wherein said illumination optical system further includes a modulator that varies wavefronts of light, on the incident side or exit side of said light integrator.

20. The light exposure apparatus according to claim 15, wherein said illumination optical system further includes divergence angle adjusting optical system for adjusting a divergence angle of the light emitted from each light source of said light source array.

21. The light exposure apparatus according to claim 20, wherein said divergence angle adjusting optical system include a cylindrical lens.

22. The light exposure apparatus according to claim 15, wherein said illumination optical system further includes light source control means for performing energy control of the light emitted from said light sources of said light source array.

23. The light exposure apparatus according to claim 15, wherein said illumination optical system further includes a detector for measuring intensity of the light emitted from said light sources of said light source array.

EP 1 646 073 A1

# FIG. 1

# FIG. 2

# FIG. 3

# FIG. 4

$W_{LDAX} = (m_x - 1) P_{LDX}$

$P_{LDX}$

$D_{LDX}$

$P_{LDXy}$

$D_{LDy}$

$H_{LDAy} = (n_y - 1) P_{LDXy}$

1

11

y

x

# FIG. 5

Wx

Hy

13

131

*FIG. 6(A)*

*FIG. 6(C)*

*FIG. 6(B)*

# FIG. 7

## FIG. 8

## FIG. 9(A)

## FIG. 9(B)

HEIGHT (ROUGHNESS) OF CROSS SECTION

# FIG. 10

## FIG. 11

# FIG. 12

# FIG. 13

# FIG. 14(A)

# FIG. 14(B)

# FIG. 15

# FIG. 16

## INTERNATIONAL SEARCH REPORT

| | International application No. |
|---|---|
| | PCT/JP03/08399 |

**A. CLASSIFICATION OF SUBJECT MATTER**
Int.Cl⁷ H01L21/027, G03F7/20, G02B19/00, G02B3/00

According to International Patent Classification (IPC) or to both national classification and IPC

**B. FIELDS SEARCHED**

Minimum documentation searched (classification system followed by classification symbols)
Int.Cl⁷ H01L21/027

Documentation searched other than minimum documentation to the extent that such documents are included in the fields searched
| Jitsuyo Shinan Koho | 1922-1996 | Jitsuyo Shinan Toroku Koho | 1996-2003 |
| Kokai Jitsuyo Shinan Koho | 1971-2003 | Toroku Jitsuyo Shinan Koho | 1994-2003 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2001-085308 A (Nikon Corp.), | 1,3,7-10,12, |
| | 30 March, 2001 (30.03.01), | 15,17,22,23 |
| Y | Full text; particularly, Par. Nos. [0007], | 2,4,5,11,13, |
| | [0012], [0015], [0029], [0053] to [0059], [0069] | 14,16,18,19 |
| A | (Family: none) | 6,20,21 |
| | | |
| X | JP 05-045605 A (Asahi Optical Co., Ltd.), | 1,2,4,8-11, |
| | 26 February, 1993 (26.02.93), | 13,15,16,18 |
| | Full text; particularly, Fig. 3 | |
| | (Family: none) | |
| | | |
| Y | JP 2000-223408 A (Hitachi, Ltd.), | 5,14,19 |
| | 11 August, 2000 (11.08.00), | |
| | Par. Nos. [0042] to [0047], [0062] to [0063]; | |
| | Figs. 1, 6 | |
| | (Family: none) | |

☒ Further documents are listed in the continuation of Box C.　☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 October, 2003 (14.10.03) | 28 October, 2003 (28.10.03) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

| | International application No. |
|---|---|
| | PCT/JP03/08399 |

| C (Continuation). DOCUMENTS CONSIDERED TO BE RELEVANT | | |
|---|---|---|
| Category* | Citation of document, with indication, where appropriate, of the relevant passages | Relevant to claim No. |
| Y<br><br>A | JP 08-330212 A (Nikon Corp.),<br>13 December, 1996 (13.12.96),<br>Par. Nos. [0005], [0013] to [0016]<br>(Family: none) | 2,4,11,13,<br>16,18<br>6,20,21 |
| E,A | JP 2003-270585 A (Ricoh Co., Ltd.),<br>25 September, 2003 (25.09.03),<br>Par. No. [0020]; Figs. 2, 3, 5<br>(Family: none) | 6,20,21 |

Form PCT/ISA/210 (continuation of second sheet) (July 1998)